# EUROPEAN PATENT SPECIFICATION

(11) **EP 2 991 037 B1**
(45) Date of publication and mention of the grant of the patent: **05.02.2020**
(21) Application number: 13883238.1
(22) Date of filing: 25.12.2013
(51) Int. Cl.: G06T 15/00, G06T 19/00, G06T 11/20

(54) **METHOD OF GENERATING THREE-DIMENSIONAL SCENE MODEL**
VERFAHREN ZUM GENERIEREN EINES DREIDIMENSIONALEN SZENEMODELLS
PROCÉDÉ DE GÉNÉRATION DE MODÈLE DE SCÈNE À TROIS DIMENSIONS

(30) Priority: 23.04.2013 CN 201310144170
(43) Date of publication of application: 02.03.2016
(73) Proprietor: Tsinghua University, Haidian District, Beijing 100084 (CN)
(72) Inventor: XU, Kun, Beijing 100084 (CN); CHEN, Kang, Beijing 100084 (CN); SUN, Weilun, Beijing 100084 (CN); HU, Shimin, Beijing 100084 (CN)
(74) Representative: Loock, Jan Pieter
(86) International application number: PCT/CN2013/090463
(87) International publication number: WO 2014/173158

(56) References cited:
- WO-A1-2006/044006
- WO-A1-2008/001967
- CN-A- 101 536 040
- CN-A- 101 657 839
- CN-A- 103 198 522
- JEEHYUNG LEE ET AL: "Sketch-based search and composition of 3D models", EUROGRAPHICS WORKSHOP ON SKETCH-BASED INTERFACES AND MODELING (2008) C. ALVARADO AND M.- P. CANI (EDITORS), 11 June 2008 (2008-06-11), pages 97-104, XP055314919, P. O. Box 16 Aire-la-Ville CH-1288 Switzerland ISSN: 1812-3503, DOI: 10.2312/SBM/SBM08/097-104 ISBN: 978-3-905674-25-5
- MATTHEW FISHER ET AL: "Example-based synthesis of 3D object arrangements", ACM TRANSACTIONS ON GRAPHICS (TOG), vol. 31, no. 6, 1 November 2012 (2012-11-01), page 1, XP055314917, US ISSN: 0730-0301, DOI: 10.1145/2366145.2366154
- MATTHEW FISHER ET AL: "Context-based search for 3D models", ACM TRANSACTIONS ON GRAPHICS (TOG), ACM, US, vol. 29, no. 6, 15 December 2010 (2010-12-15), pages 1-10, XP058167647, ISSN: 0730-0301, DOI: 10.1145/1882261.1866204
- KUN XU ET AL: "Sketch2Scene", ACM TRANSACTIONS ON GRAPHICS (TOG), vol. 32, no. 4, 1 July 2013 (2013-07-01), page 1, XP055236263, US ISSN: 0730-0301, DOI: 10.1145/2461912.2461968

## Description

### Technical Field

The present invention relates to the field of three-dimensional technology, especially relates to three-dimensional scene model generating method, and in particular to a three-dimensional scene model generating method based on sketches.

### Background

With the increase of the number of three-dimensional models on the Internet (e.g., model libraries such as Google 3D Warehouse or the like) and the development of the growing mature technology of retrieving three-dimensional models via two-dimensional sketches, the technology of reasonably utilizing a single model to combine a necessary scene becomes possible. A large number of studies show that randomly drawn two-dimensional sketches can be both used for retrieving models and providing the position information of objects in scenes to help to optimize the placement of scene models, which greatly reduces the modeling workload. The technical background of the present invention is mainly derived from the above-mentioned two aspects.

The most mainstream method of retrieving models via sketches is the paper entitled "How do humans sketch objects" and contents described in the quotation thereof. These methods are dedicated to improving the model retrieval effect of a single sketch, often with little regard for the semantic relationship between the models in the scenes. Moreover, due to the limitations of the two-dimensional sketches, great ambiguity exists in the expression of contents and spatial relationships, and these methods are only highly dependent on users to resolve these ambiguities.

In recent years, some progress has been made on researches of automatic optimization of three-dimensional model positions, and the main target of these researches is to place the models on reasonable positions to form beautiful scenes. The most direct application is how to automatically determine the placement positions of all kinds of furniture to make a room become beautiful and comfortable. These researches mainly include: "Interactive furniture layout using interior design guidelines", "Make it home: automatic optimization of furniture arrangement", "Context-based search for 3D models", etc.

At present, the major mainstream methods of generating three-dimensional models based on sketches, such as "Magic canvas: interactive design of a 3-d scene prototype from freehandsketches", "Sketch-Based Search and Composition of 3D Models", "Sketch-to-Design: Context-based Part Assembly", are all based on the design mode of a single object: retrieving the three-dimensional models from the two-dimensional sketches at first, and then placing the models. Since the semantic relationships of objects are not considered, the effects of these methods require that the required model must be accurately retrieved from each sketch. To do this, these systems require a large amount of user intervention and require a lot of professional knowledge as well.

### Summary

### (1) Technical problem to be solved

The technical problem to be solved in the present invention is to provide a three-dimensional scene model generating method, which is used for overcoming the defects in the prior art and automatically generating an accurate and beautiful three-dimensional scene from an input sketch on the premise of minimal user intervention.

### (2) Technical solutions

The present invention provides a three-dimensional scene model generating method according to the appended claim 1.

Wherein, in S11, a common object structure group with a highest association degree and defined by the Apriori algorithm is extracted from the scene by means of data mining association rules;
wherein S23 specifically includes: directly projecting objects placed on the ground onto the ground in the scene according to a certain proportion, matching supporting surfaces of objects placed on other objects from the input sketch by means of an image method, interpolating on the supporting surfaces, and calculating the positions of the objects relative to the supporting objects.

Wherein, in S11, the plurality of object structure groups include at least one object structure group.

### (3) Beneficial effects

By adopting the method provided by the present invention, the semantic information of the scene is fully utilized to improve the accuracy of the model retrieval method based on sketches, and the ambiguity in the input sketch is automatically solved on the premise of minimal user intervention, so that users without professional knowledge can create scene models comparable with those created by the professionals by means of the system in the present invention. In addition, the present invention has good scalability, and the proposed conception of structure groups can also provide a thought for solving problems in other fields.

### Brief Description of the Drawings

Fig. 1 is a flowchart of steps of a three-dimensional scene model generating method in the present invention;
Fig. 2 is a processing flowchart of example 1 of a three-dimensional scene model generating method based on sketches in the present invention;
Fig. 3 is a schematic diagram of a part of results of a three-dimensional scene model generating method based on sketches and a result made on the same model library.

### Detailed Description of the Preferred Embodiments

A further detailed description of specific implementation manners of the present invention will be given below in combination with accompanying drawings and embodiments. The following embodiments are used for illustrating the present invention, rather than limiting the scope of the present invention.

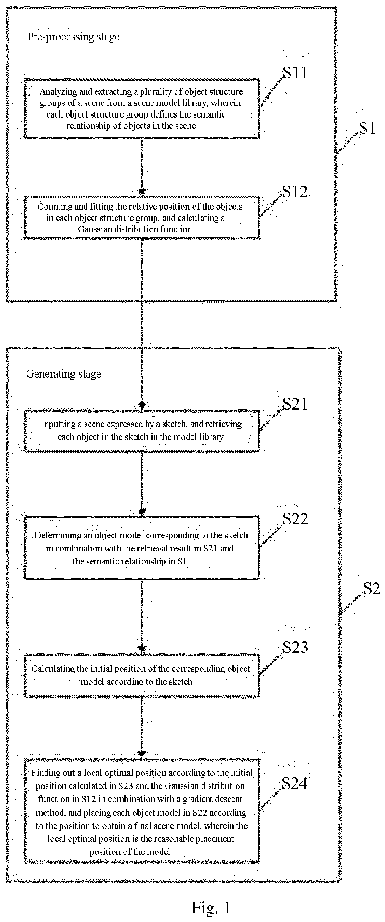

As shown in Fig. 1, the present invention provides a three-dimensional scene model generating method, including:
S1: pre-processing stage:
   S11: analyzing and extracting a plurality of object structure groups of a scene from a scene model library, wherein each object structure group defines the semantic relationship of objects in the scene;
   S12: counting and fitting the relative position of the objects in each object structure group, and calculating a Gaussian distribution function;
S2: generating stage:
   S21: inputting a scene expressed by a sketch, and retrieving each object in the sketch in the model library;
   S22: determining an object model corresponding to the sketch in combination with the retrieval result in S21 and the semantic relationship in S1;
   S23: calculating the initial position of the corresponding object model according to the sketch;
   S24: finding out a local optimal position according to the initial position calculated in S23 and the Gaussian distribution function in S12 in combination with a gradient descent method, and placing each object model in S22 according to the position to obtain a final scene model, wherein the local optimal position is the reasonable placement position of the model.

Wherein, in S11, a common object structure group with a highest association degree and defined by the Apriori algorithm is extracted from the scene by means of data mining association rules; (the Apriori algorithm is a frequent itemset algorithm used for mining the association rules, and the core idea thereof is to mine a frequent itemset by two stages of candidate set generation and downward scenario closure detection. Moreover, the algorithm has been widely used in various fields, such as business, network security and the like.)

Wherein, S23 specifically includes: directly projecting objects placed on the ground onto the ground in the scene according to a certain proportion, matching supporting surfaces of objects placed on other objects from the input sketch by means of an image method, interpolating on the supporting surfaces, and calculating the positions of the objects relative to the supporting objects.

Wherein, in S11, the plurality of object structure groups include at least one object structure group.

### Embodiment 1

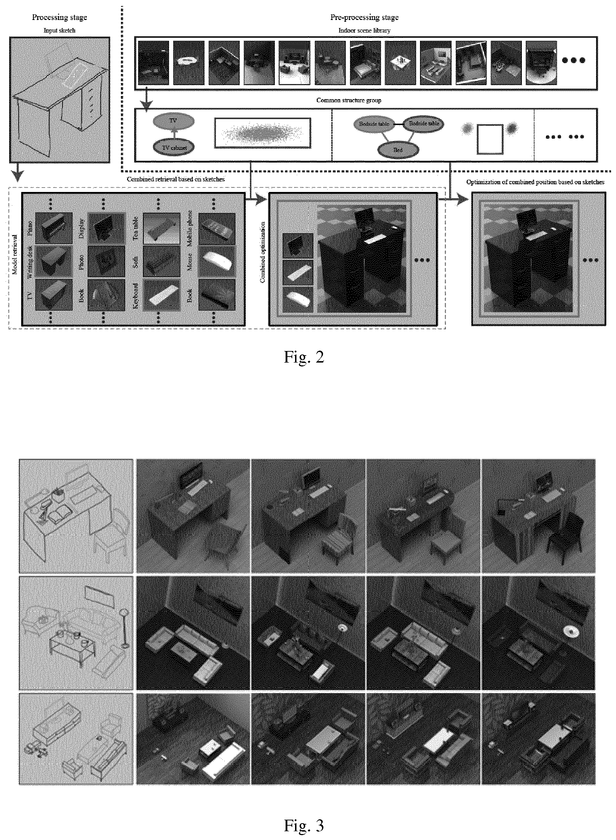

Fig. 2 is a processing flowchart of example 1 of a three-dimensional scene model generating method based on sketches in the present invention, and as shown in Fig. 2:

### (1) Processing stage:

Common structure groups are analyzed and extracted from a scene database at the stage. For example, Fig. 1 shows two structure groups "TV-cabinet" and "bedside table--bed--bedside table". In the first structure group, the relationship between "TV" and "cabinet" is that the "TV" is placed on the "cabinet" and it can be seen from a fitted Gaussian function that the center of the "TV" is distributed relatively to the center of the "cabinet". In the second structure group, the "bed" and the two "bedside tables" are all placed on the ground, and the two "bedside tables" are generally placed at approximately symmetrical positions at both sides of the "bed".

### (2) Operation stage:

The operation state is composed of the following four parts:
a. a scene sketch is input, it can be seen that different objects in the scene sketch are expressed by different colors and the scene sketch is well "divided".
b. The sketch of each object in the input scene sketch is matched with outline images generated from different visual angles of all the models in a model library by using an image matching method, and all the models in the model library are sequenced in a descending order according to similarity. It can be seen that each expected category of model cannot be guaranteed to be ranked at the first due to the limitation of a single sketch retrieval model.
c. Former 100 candidate models are extracted from each object sketch for combination and optimization, besides considering the sketch matching score, if containing the structure group extracted at the pre-processing stage, the score of a pre-defined structure group will be added in each combination. The combination with the highest score is extracted in a greedy manner, in order to obtain a final model corresponding to each object in the scene sketch. The position of each model is estimated from the sketch, and the models are placed on respective estimated positions.

A potential function relevant to object translation and rotation is defined, and the potential function simultaneously requires that the relative position relationship of the objects in the structure group contained in the scene obeys the preset Gaussian function as much as possible and requires that the position and direction of each object cannot be too far away from the initial estimated position. A locally optimal solution is found out by a gradient descent method, and the models are placed on finally determined positions.

As shown in Fig. 3, the first column is some input sketches, and the second column is scenes made by invited professional art designers on the same model library according to the sketches. The third, fourth and fifth columns are results automatically generated by the system in the present invention. It can be seen that, the results generated in the present invention basically have the same visual effects as the results made by the art designers.

The above-mentioned embodiments are merely used for illustrating the present invention, rather than limiting the present invention. Those of ordinary skill in the art can make various variations and deformations without departing from the scope of the present invention. Accordingly, all the equivalent technical solutions belong to the scope of the present invention, and the protection scope of the present invention should be defined by the claims.

## Claims

1. A three-dimensional scene model generating method, comprising:
S1: a pre-processing stage comprising :
S11: analyzing and extracting a plurality of object structure groups of a scene from a scene model library, wherein each object structure group defines the semantic relationship of objects in the scene;
S12: calculating a Gaussian distribution function of the relative position of the objects in each object structure group;
S2: a generating stage comprising :
S21: inputting a scene expressed by a sketch, and retrieving candidate models for each object in the sketch in the model library;
S22: determining an object model corresponding to the sketch based on the retrieval result in S21 and the semantic relationship in S1;
S23: calculating the initial position for each of the corresponding object model according to the sketch;
S24: finding out a local optimal position according to the initial position calculated in S23 and the Gaussian distribution function in S12 using a gradient descent method, and placing each object model of S22 according to the local optimal position to obtain a final scene model, wherein the local optimal position is the placement position of the model.

2. The method of claim 1, wherein in S11, a common object structure group with a highest association degree and defined by the Apriori algorithm is extracted from the scene by means of data mining association rules.

3. The method of claim 1, wherein S23 specifically comprises: directly projecting objects placed on the ground onto the ground in the scene according to a certain proportion, matching supporting surfaces of objects placed on other objects from the input sketch by means of an image method, interpolating on the supporting surfaces, and calculating the positions of the objects relative to the supporting objects.

4. The method of claim 1, wherein in S11, the plurality of object structure groups comprise at least one object structure group.

## Patentansprüche

1. Verfahren zum Erzeugen eines dreidimensionalen Szenemodells, umfassend:
S1: eine Vorverarbeitungsstufe, umfassend:
S11: Analysieren und Extrahieren einer Mehrzahl von Objektstrukturgruppen einer Szene aus einer Szenenmodellbibliothek, wobei jede Objektstrukturgruppe die semantische Beziehung von Objekten in der Szene definiert;
S12: Berechnen einer Gaußschen Verteilungsfunktion der relativen Position der Objekte in jeder Objektstrukturgruppe;
S2: eine Erzeugungsstufe, umfassend:
S21: Eingeben einer durch eine Skizze ausgedrückten Szene und Abrufen von Kandidatenmodellen für jedes Objekt in der Skizze in der Modellbibliothek;
S22: Festlegen eines Objektmodells entsprechend der Skizze, basierend auf dem Abfrageergebnis in S21 und der semantischen Beziehung in S1;
S23: Berechnen der Anfangsposition für jedes der entsprechenden Objektmodelle gemäß der Skizze;
S24: Ermitteln einer optimalen lokalen Position entsprechend der in S23 berechneten Anfangsposition und der Gaußschen Verteilungsfunktion in S12 unter Verwendung eines Gradientenverfahrens und Platzieren jedes Objektmodells von S22 entsprechend der optimalen lokalen Position, um ein finales Szenemodell zu erhalten, wobei die optimale lokale Position die Platzierungsposition des Modells ist.

2. Verfahren nach Anspruch 1, wobei in S11 eine gemeinsame Objektstrukturgruppe mit einem höchsten Zuordnungsgrad, die durch den Apriori-Algorithmus definiert ist, mittels Data-Mining-Assoziationsregeln aus der Szene extrahiert wird.

3. Verfahren nach Anspruch 1, wobei S23 im Einzelnen umfasst: Direktes Projizieren von auf dem Boden platzierten Objekten auf den Boden in der Szene entsprechend einem bestimmten Verhältnis, Abgleich unterstützender Oberflächen von auf anderen Objekten aus der Eingabeskizze platzierten Objekten mittels eines Bildverfahrens, Interpolation auf den unterstützenden Oberflächen, und Berechnen der Positionen der Objekte relativ zu den unterstützenden Objekten.

4. Verfahren nach Anspruch 1, wobei in S11 die Mehrzahl von Objektstrukturgruppen mindestens eine Objektstrukturgruppe umfasst.

## Revendications

1. Procédé de génération de modèles de scènes en trois dimensions, comprenant :
S1 : une étape de pré-traitement comprenant de :
S11 : analyser et extraire une pluralité de groupes de structures d'objets d'une scène à partir d'une bibliothèque de modèles de scènes, dans lequel chaque groupe de structures d'objets définit la relation sémantique d'objets dans la scène;
S12 : calculer une fonction de distribution gaussienne de la position relative des objets dans chaque groupe de structure d'objets;
S2 : une étape de génération comprenant de :
S21 : entrer une scène exprimée par une esquisse, et récupérer des modèles candidats pour chaque objet dans l'esquisse dans la bibliothèque de modèles;
S22 : déterminer un modèle d'objet correspondant à l'esquisse sur la base du résultat de récupération en S21 et de la relation sémantique en S1;
S23 : calculer la position initiale pour chacun des modèles d'objets correspondant en fonction de l'esquisse;
S24 : rechercher une position optimale locale en fonction de la position initiale calculée en S23 et de la fonction de distribution gaussienne en S12 en utilisant un procédé de descente de gradient, et placer chaque modèle d'objet de S22 en fonction de la position optimale locale pour obtenir un modèle de scène final, dans lequel la position optimale locale est la position de placement du modèle.

2. Procédé selon la revendication 1, dans lequel dans S11, un groupe de structures d'objets commun avec un degré d'association le plus élevé et défini par l'algorithme Apriori est extrait de la scène au moyen de règles d'association d'exploration de données.

3. Procédé selon la revendication 1, dans lequel S23 comprend spécifiquement de : projeter directement des objets placés sur le sol sur le sol dans la scène en fonction d'une certaine proportion, apparier des surfaces de support d'objets placés sur d'autres objets de l'esquisse d'entrée au moyen d'un procédé d'image, interpoler les surfaces de support,
et calculer les positions des objets par rapport aux objets de support.

4. Procédé selon la revendication 1, dans lequel, dans S11, la pluralité de groupes de structures d'objets comprend au moins un groupe de structures d'objets.
